# EUROPEAN PATENT SPECIFICATION

(11) **EP 0 829 881 B1**
(45) Date of publication and mention of the grant of the patent: **26.03.2003**
(21) Application number: 97830445.9
(22) Date of filing: 10.09.1997
(51) Int. Cl.: G11C 8/00

(54) **Wordline drive circuit for flash EEPROM memory**
Wortleitungstreiberschaltung für Flash-EEPROM-Speicher
Circuit d'attaque de ligne de mot pour mémoire EEPROM flash

(30) Priority: 13.09.1996 IT RM960626
(43) Date of publication of application: 18.03.1998
(73) Proprietor: TEXAS INSTRUMENTS INCORPORATED, Dallas, Texas 75243 (US); TEXAS INSTRUMENTS ITALIA S.p.A., 67051 Avezzano (AQ) (IT)
(72) Inventor: Menichelli, Stefano, 00177 Roma (IT); Vali, Tommaso, 04018 Sezze (LT) (IT)
(74) Representative: Taliercio, Antonio

(56) References cited:
- EP-A- 0 356 650
- US-A- 5 455 789

## Description

This invention broadly relates to drive circuits for semiconductor memories and more particularly concerns a row drive circuit for low voltage Flash EEPROM memories.

As it is known, in implementing memory circuits, particularly Flash EEPROM memories, a problem arises in connection with the simultaneous existence within the circuit of logic signals as well as of signals variable within an extended voltage range and consequently with the need of simultaneous management of them. Such variable signals within an extended voltage range are intended to be used in the various operation modes of the memory, such as the read or programming or erasure operations. The logic signals, on the other hand, are control signals and are variable between ground voltage, as indicated by GND, and the supply voltage, as indicated by VDD. The normal supply voltage in these circuits, which are also designated as low voltage or low power circuits, is presently of about 3.3 volts, while the voltage used for performing operations such as internal programming or erasure operations can also reach 12 volts (for instance, 5 volts for read operations).

On the one side, this entails the need to implement various circuits on the chip to generate such higher voltages starting from the low supply voltage of 3.3 volts, and, on the other side, this entails the need to implement suitable circuits within the memory itself adapted to handle or manage these voltages higher than the supply voltage, without introducing time delays incompatible with proper operation of the memory and consequently without affecting its access times. The essential requirement of these circuits, therefore, is related to their operation speed: these circuits are defined as voltage translators.

This invention is not aimed at generating such operation voltages higher than the supply voltage, but it is an object thereof to handle these voltages in very fast manner, while also a space saving is achieved on the silicon area.

More precisely, it is an object of this invention to provide a voltage translator circuit which, even if logic signals in a voltage range of 0 to 3.3 volts are applied to its input port and even if voltages in the range of -9 to 12 volts as generated by other suitable circuits are available thereto, is adapted to furnish output voltages fully variable within the latter range and also adapted to operate in very fast manner; in the same time, such circuit ought to need a small silicon area for implementation.

Since the read time of a memory is a substantial feature thereof and since all read operations require a voltage higher than the supply voltage, the main but, of course, not exclusive application of this invention is to be identified in a row drive circuit for Flash EEPROM memories, by operating as a voltage translator circuit designed to couple such above mentioned read voltages to selected rows or wordlines of the memory.

Summarising all above said, in present Flash EEPROM memory technology with a supply voltage of 3.3 volts, the read operation are carried out by driving the selected wordline to 5 volts and all non-selected wordlines to ground GND. When other operations are to be carried out, such as programming or erasure operations, the concerned wordlines should be driven to other voltages, typically in the range -9 volts to 12 volts. High voltage transistors should be used, therefore, in said row drive circuits, in order to accommodate these voltages noticeably higher than the supply voltage. In P-channel or N-channel MOS transistor technology, said high voltage transistors offer rather poor performances with respect to low voltage transistors, as it is well known to those skilled in the art, due to the noticeable thickness of the required gate oxide. This is really the core of the problem, since in very fast applications, such as the above mentioned memories, with an access time in the range of 10 to 20 nsec, the row drive circuit should drive the selected wordlines in a very fast manner, even if high voltage transistor are employed, due to the fact that any delay in coupling the wordline driving voltages directly and adversely affects the memory access time.

EP-A-0 356 650 discloses a circuit for applying reading, programming and erasing voltages to a worldline in a floating-gate type EEPROM cell array comprising a positive voltage switching circuit, at least one first isolating transistor and a second isolating transistor. The positive voltage switching circuit may include an inverter with a feedback transistor and a third isolating transistor.

Starting, therefore, from a situation entailing a Flash EEPROM memory having logic control voltages in the range of 0 to 3.3 volts as well as operation voltages (VX) for effecting read, programming or erasure operations in the range of -9 to 12 volts and comprising a decode section schematically represented as a NOR gate circuit which receives the selection signals coupled to an input node of an inverter circuit, it is specific subject-matter of this invention to provide a voltage translator circuit to drive the rows or wordlines of a memory, wherein:
- the output node is connected to ground through a first N-MOS type switch transistor, the gate of which is driven by a selection logic signal applied through said inverter circuit gate circuit and said inverter circuit and connected to the operation voltage through a second P-MOS type switch transistor,
- a first P-MOS type feedback transistor, has a gate directly driven by said output node, said first feedback transistor being inserted between the operation voltage and the gate region of said second switch transistor,
- a second N-MOS type feedback transistor, has a gate directly driven by said output node, said second feedback transistor being inserted between the connection node of said first feedback transistor and the gate of said second switch transistor and the input node of the gate of said first switch transistor, and wherein
the connection node between said first feedback transistor and the gate region of said second switch transistor is connected to ground through a decoupling transistor of N-MOS type, the gate of which is driven by the selection signal once inverted and coming from the connection node between said decode section and said inverter circuit.

Further details and advantages of this invention will be evident from the following specification by referring to the enclosed drawings wherein the preferred embodiment is shown by way of illustration and not by way of limitation.

In the drawings:
Figure 1 shows a diagram of a conventional row drive circuit,
Figure 2 is a waveform diagram of the meaningful voltages in the circuit of Figure 1,
Figure 3 shows a diagram of a row drive circuit according to this invention,
Figure 4 is a waveform diagram of the meaningful voltage in the circuit of Figure 3.

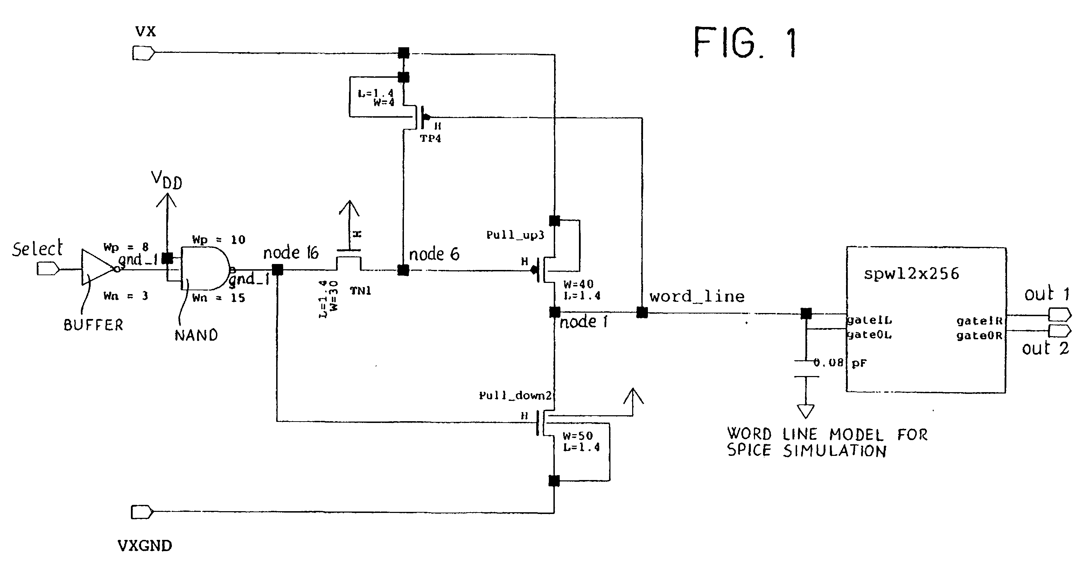

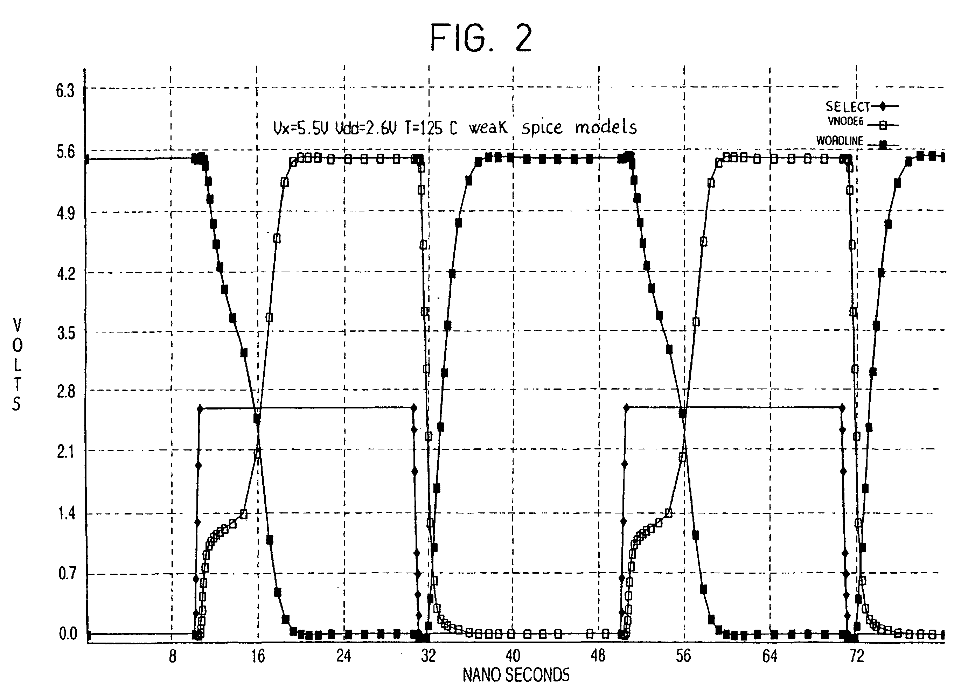

The operation of a conventional circuit will be now explained by referring to Figures 1 and 2.

It should be preliminary underlined that the inverter circuit BUFF and the NAND gate circuit of Figure 1 should not be considered as real and individual components of the circuit we are now discussing, but they are rather symbolically indicated as representatives of the pre-existing row decode section and are shown only for explanation clarity purposes A further specification relates to the fact that VX and VXGND generically designate the operation voltage and the ground voltage to be translated to the concerned wordline.

In the circuit we are examining, the wordline is connected through node 1 to voltage VX and to ground VXGND, respectively, by means of a P-channel transistor pull-up 3 and a N-channel transistor pull-down 2, effectively operating as switches. The gate region of transistor pull-down 2 is connected to input node 16, while the gate region of transistor pull-up 3 is connected to node 6. A feedback P-channel transistor TP4 is inserted between the operation voltage VX and the gate region of transistor pull-up 3, on node 6. The gate region of feedback transistor TP4 is directly driven by the wordline.

The operation is as follows. When a selection signal having a logic value 1 is available on the input lead, it will be inverted to a 0 value by inverter circuit BUFF and again inverted to a 1 value by the NAND gate circuit, on node 6. This signal, which is a low voltage signal because it is a logic signal, turns on transistor pull-down 2, that, upon turning on, takes node 1 and consequently the related wordline to ground VXGND. This lowered wordline voltage is transferred to the gate region of feedback transistor TP4 which will be turned on. Since transistor TP4 is inserted between voltage VX and the gate region of transistor pull-up 3 through node 6, transistor TP4 upon turning on will raise the voltage on node 6 to VX, with the resulting consequence that transistor pull-up 3 will be completely turned off. In this manner, the wordline is perfectly connected to VXGND through transistor pull-down 2 which is on and it is perfectly insulated from voltage VX by means of transistor pull-up 3 which is off.

In order to prevent the high voltage VX from affecting the logic section of the circuit, which is at low voltage, a decoupling transistor TN1 is inserted between node 6 and node 16.

All above mentioned transistors are of high voltage type, as indicated by literal designation H in the drawing.

The need to use a feedback transistor TP4 is due to the fact that the logic voltage available on node 6 and consequently on gate region of transistor pull-up 3 would not be sufficient to turn transistor pull-up 3 off: in fact, it can be observed that it is connected to voltage VX that, in this application, is of 5 volts, and, therefore, its gate region would be at a too high voltage for it to be driven by said input logic voltage.

After having examined a starting condition wherein the concerned wordline has been lowered from voltage VX to ground VXGND, the opposite switch over action will now be analysed.

When the selection signal toggles to logic state 0, a logic state 1 will be established at the output of the inverter circuit BUFF and again a logic state 0 will be established at the output of the NAND gate circuit, on node 16. A 0 logic voltage on node 16, when applied to the gate region of transistor pull-down 2, will force the latter to turn off with consequent insulation or decoupling of the wordline from ground VXGND. In addition, this logic voltage 0 is applied though transistor TN1 and node 6 to the gate region of transistor pull-up 3 and will force it to turn on, thereby raising the wordline voltage up to VX. Since the concerned wordline is connected to the gate region of the feedback transistor TP4, as the wordline voltage is raised, the conduction capability of transistor TP4 is lowered down to the point that said transistor is turned off, which occurs when the wordline is raised just to voltage VX. When transistor TP4 is off, transistor pull-up 3 is on and the concerned wordline is directly connected to voltage VX and completely insulated by means of said transistor pull-up 3 in off condition.

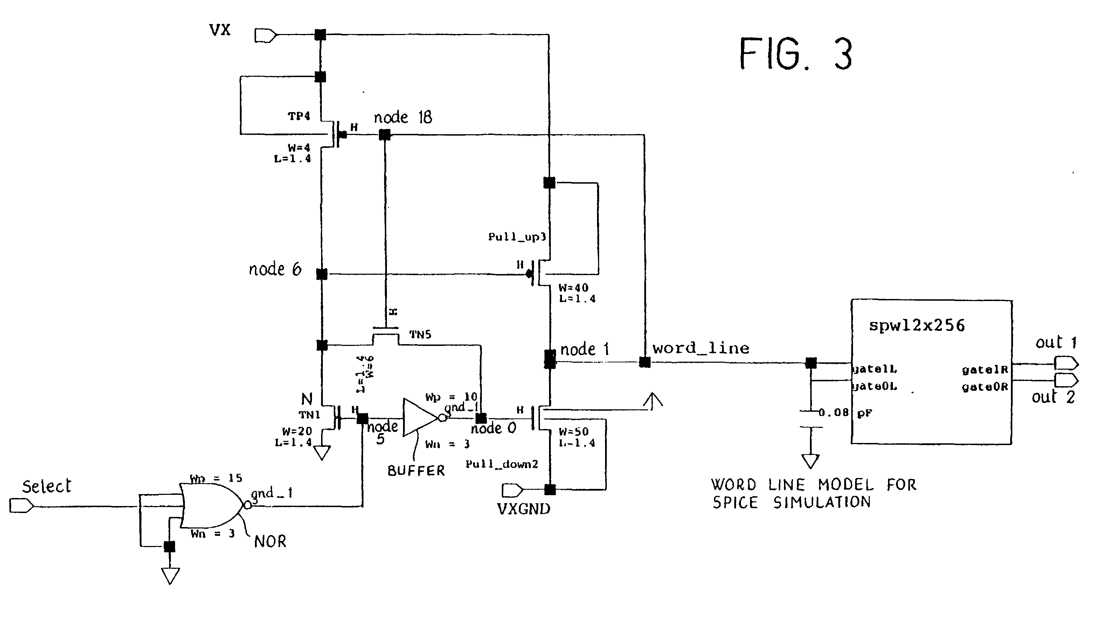

In order to improve the performances of this circuit particularly in respect of its operation speed, this invention suggests to adopt the circuit approach shown in Figure 3.

It should be understood that the decode functions carried out by inverter circuit BUFF and by subsequent NAND gate circuit can be carried out by NOR gate circuit of Figure 3.

It can be observed in Figure 3 that the concerned wordline is again connected to operation voltage VX by means of a P-channel transistor pull-up 3 and to ground VXGND by means of a N-channel transistor pull-down 2. It can also be observed that a feedback transistor TP4 is provided, the gate region of which is directly driven by the wordline, inserted between voltage VX and the gate region of transistor pull-up 3, through node 6. This circuit is substantially distinguished with respect to the known circuit by means of a further N-channel feedback transistor TN5, the gate of which is again directly driven by the wordline, inserted between node 6, more precisely the gate region of transistor pull-up 3, and the gate region of transistor pull-down 2. It is also to be observed that a N-channel transistor TN1 is inserted between node 6 and ground, said transistor TN1 having its gate region driven by said node 6 and consequently by the same selection signal upon a single inversion.

The operation takes place as follows. When the selection logic signal is at 0 level, node 5 is at 1 logic level, corresponding to the supply voltage VDD. Transistor TN1, which is driven by inverted selection signal, is turned on and forces node 6 to 0 logic level. As soon as node 6 is forced to 0 logic level, transistor pull-down 2 is turned off because the 1 logic level signal on node 5 is again inverted by inverter circuit BUFF and becomes a 0 logic level signal on node 0 and consequently on gate region of transistor pull-down 2 which is turned off.

When transistor TN5 is considered, it can be observed that a voltage of 0 volt is established on node 0 and again a voltage of 0 volt is established on node 6, as above already seen, due to the on condition of transistor TN1.

Since node 6 is at 0 level and transistor pull-down 2 is in off condition, transistor pull-up 3 will be turned on and it will cause the wordline to begin to rise to voltage VX. By rising to voltage VX, the wordline will cause the feedback transistor TP4 to be turned off through node 18. On the other hand, a higher voltage on node 18 will entail a higher voltage on the gate region of N-channel transistor TN5, but, since a 0 logic level exists both on node 6 and on node 0, namely at the ends of this transistor, the on condition of transistor TN5 will have no effect. As a final result, the concerned wordline will be raised to voltage VX and will be completely decoupled from voltage VXGND.

When a switch over operation in the opposite direction is to be carried out, when the selection signal is turned from a 0 logic level to a 1 logic level, node 5 will take up the inverted level 0 and, as a result, transistor TN1 will be turned off and will clear node 6, that is to say it will decouple it from ground voltage GND. Following a further inversion of the signal effected by inverter circuit BUFF, node 0 will turn to level 1 and it will drive the gate region of transistor pull-down 2 so as to turn it on, while the voltage on node 0 will be completely translated to node 6 through the second feed-back transistor TN5. In fact, since voltage VX resulting from the previous switch over operation is still applied to the gate region of transistor TN5 from node 18 and from the concerned wordline, transistor TN5 is still on.

The following situation is utilised in this switch over operation: the wordline is still at voltage VX and transistor TN5 is on. The signal of 0 logic level that is prevailing on node 0 not only turns transistor pull-down 2 on - and this is its main object - but it also transfers a charge of a certain amount to node 6 and in this manner it succeeds in slightly raising the voltage of node 6. As a matter of fact, node 6 rises to a level slightly higher than the lever it would reach in absence of transistor TN5. When the voltage on node 6 rises at higher rate, a double effect is obtained, namely to aid and to accelerate turning P-channel transistor pull-up 3 off, since it is connected to its gate region.

In this operation stage, the following operation pattern is established: the voltage on node 6 is rising, transistor pull-down 2 is turned on thereby aiming at lowering the wordline voltage. When the voltage is near to 0, it begins turning transistor TN5 off, but it should be observed that an initial trigger action occurs that enables the turning action on transistor pull-up 3 to be started and consequently to be advanced by a small amount, thereby reducing the transition time. Since the voltage on node 6 is rising, transistor pull-up 3 is turning off, and, therefore, the voltage of the wordline is being lowered to 0: as it gets nearer and nearer to 0, it turns the second N-channel feedback transistor TN5 off, but it also turns the first feedback transistor TN4 on, which, in turn, completes turning transistor pull-up 3 off. At this point, since transistor pull-up 3 is turned off and transistor pull-down 2 is turned on, the wordline is decoupled from voltage VX and is coupled to voltage VXGND.

The essential feature of this circuit just consists in exploiting the above described second feedback effect between node 0 and node 6: this feedback effect is assured by transistor TN5 that, in transition from 0 to 1, utilises its pre-existing conductive condition connected with the pre-existing condition of the wordline.

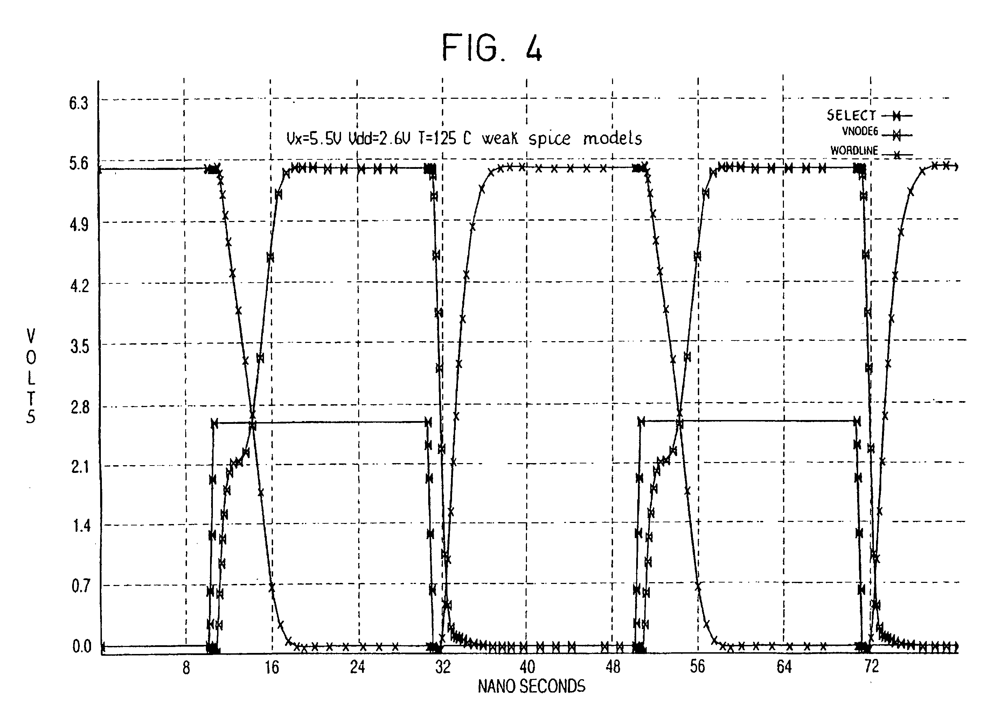

By referring to Figures 2 and 4, wherein the selection voltage behaviours on node 6 and on the wordline are shown, it is evident that the voltage on node 6 rises to a level slightly higher than the level reached in a conventional circuit. A faster voltage rise time on node 6 means that transistor pull-up 3 is turned off faster and this, in turn, means a faster decrease of the wordline voltage which is decoupled from voltage VX.

In order to complete these observations, it is to be remarked that, while the first feedback effect assured by transistor TP4 is a feedback effect between the output and the input ends of the circuit, the second feedback effect is introduced and promoted directly from the input end of the circuit, since its output is only intended to pre-establish a conductive condition in transistor TN5. Transistor PN5 does not receive its control signal from the output end; but it receives such signal from the input end of the circuit, with an advance time, thereby promoting the above defined starting effect.

The above result has been achieved at expenses of the fact that node 18 has been loaded by said transistor TN5, but this drawback, in addition to being largely counterbalanced by said starting effect, is quite tolerable, from a process view point, in view of the reduced dimensions of said transistor, which are for instance L = 1.4 and W = 6.

A further advantage of the approach according to this invention, connected with the substitution of a NOR gate circuit for the NAND gate circuit, is gained in reducing the silicon area needed for its implementation.

In fact, it is known that the row drive circuits in the memory topology should have the same Y dimension as the memory array. This entails that any reduction achieved in the X dimension of the circuit will result into a more relevant reduction in its comprehensive area, since such a reduction will be extended over the whole Y dimension of the circuit. Then, when it is desired to save silicon area, it is substantially important to design the concerned drive circuits with their width dimensions as much compact as possible. The difference between the conventional approach and the approach according to this invention has been investigated by adding all W values together and it has been found that the approach according to this invention entails a cumulative W dimension smaller than the one of a conventional approach: this means a two-fold advantage in terms of better performances with a smaller silicon area.

The preferred embodiment of this invention has been hereinbefore explained, but it should be understood that those skilled in the art can make variations and changes to the components therein without so departing from the scope of this invention.

## Claims

1. A voltage translator circuit for driving rows or wordlines of Flash EEPROM memories, said translator circuit having an output node (node 1) adapted to be connected to one of said rows or worldlines and being arranged for receiving control logic voltages in the range 0 to 3.3 volts, and operating voltages for performing reading, programming or erasing operations in the range -9 to 12 volts, said translator circuit comprising a decode section (NOR) connected to an inverter circuit (BUFF) through an input node (node 5) to couple a selection signal thereto, wherein:
- the output node (node 1) is connected to ground (VXGND) through a first N-MOS type switch transistor (pull-down 2) the gate of which (node 0) is driven by a selection logic signal applied through said inverter circuit (BUFF) and connected to the operation voltage (VX) through a second P-MOS type switch transistor (pull-up 3),
- a first P-MOS type feedback transistor (TP4) has a gate (node 18) directly driven by said output node (node 1), said first feedback transistor being inserted between the operation voltage (VX) and the gate region (node 6) of said second switch transistor (pull-up 3),
- a second N-MOS type feedback transistor (TN5) has a gate directly driven by said output node (node 1), said second feedback transistor being inserted between the connection node (node 6) between said first feedback transistor (TP4) and the gate region of said second switch transistor (pull-up 3) and the input node (node 0) of the gate of said first switch transistor (pull-down 2), and
wherein the connection node (node 6) between said first feedback transistor (TP4) and the gate of said second switch transistor (pull-up 3) is connected to ground through a decoupling transistor (TN1) of N-MOS type, the gate of the decoupling transistor being driven by the selection signal received from the connection node (node 5) between said decode section (NOR) and said inverter circuit (BUFF).

2. A voltage translator circuit according to claim 1, **characterised in that** said switch transistors (pull-up 3, pull-down 2), said feedback transistors (TP4, TN5) and said decoupling transistor (TN1) are high voltage (H) transistors.

## Revendications

1. Circuit traducteur de tension pour piloter des rangées ou lignes de mots de mémoires flash EEPROM, ledit circuit traducteur ayant un noeud de sortie (noeud 1) destiné à être connecté à une desdites rangées ou lignes de mots et étant agencé pour recevoir des tensions logiques de commande dans la gamme comprise entre 0 et 3,3 volts, et des tensions de fonctionnement pour effectuer des opérations de lecture, de programmation ou d'effacement dans la gamme comprise entre -9 et 12 volts, ledit circuit traducteur comprenant une section de décodage (NOR) connectée à un circuit inverseur (BUFF) par un noeud d'entrée (noeud 5) afin de coupler un signal de sélection à celui-ci, dans lequel :
- le noeud de sortie (noeud 1) est connecté à la masse (VXGND) par un transistor de commutation de type NMOS (excursion basse 2) dont la grille (noeud 0) est pilotée par un signal logique de sélection appliqué par ledit circuit d'inversion (BUFF) et connecté à la tension de fonctionnement (VX) par un deuxième transistor de commutation de type PMOS (excursion haute 3),
- un premier transistor de rétroaction de type PMOS (TP4) a une grille (noeud 18) pilotée directement par ledit noeud de sortie (noeud 1), ledit premier transistor de rétroaction étant inséré entre la tension de fonctionnement (VX) et la région de grille (noeud 6) dudit deuxième transistor de commutation (excursion haute 3),
- un deuxième transistor de rétroaction de type NMOS (TN5) a une grille pilotée directement par ledit noeud de sortie (noeud 1), ledit deuxième transistor de rétroaction étant inséré entre le noeud de connexion (noeud 6) entre ledit premier transistor de rétroaction (TP4) et la région de grille dudit deuxième transistor de commutation (excursion haute 3) et le noeud d'entrée (noeud 0) de la grille dudit premier transistor de commutation (excursion basse 2), et dans lequel le noeud de connexion (noeud 6) entre ledit premier transistor de rétroaction (TP4) et la grille dudit deuxième transistor de commutation (excursion haute 3) est connecté à la masse par un transistor de découplage (TN1) de type NMOS, la grille du transistor de découplage étant pilotée par le signal de sélection reçu du noeud de connexion (noeud 5) entre ladite section de décodage (NOR) et ledit circuit inverseur (BUFF).

2. Circuit traducteur de tension selon la revendication 1, **caractérisé en ce que** lesdits transistors de commutation (excursion haute 3, excursion basse 2), lesdits transistors de rétroaction (TP4, TN5) et ledit transistor de découplage (TN1) sont des transistors pour tensions élevées (H).

## Patentansprüche

1. Spannungsübersetzungsschaltung zum Ansteuern von Zeilen oder Wortleitungen von Flash-EEPROM-Speichern, wobei die Übersetzungsschaltung einen Ausgangsknoten (Knoten 1) besitzt, der mit einer der Zeilen oder Wortleitungen verbunden werden kann und so beschaffen ist, daß er Steuerlogikspannungen im Bereich von 0 bis 3,3 Volt und Betriebsspannungen für die Ausführung von Lese-, Programmierungs- oder Löschoperationen im Bereich von -9 bis 12 Volt empfängt, wobei die Übersetzungsschaltung einen Decodierungsabschnitt (NOR) umfaßt, der über einen Eingangsknoten (Knoten 5) mit einer Inverterschaltung (BUFF) verbunden ist, um in diese ein Auswahlsignal einzukoppeln, wobei:
- der Ausgangsknoten (Knoten 1) mit Masse (VXGND) über einen ersten N-MOS-Schalttransistor (pull-down 2) verbunden ist, dessen Gate (Knoten 0) durch ein über die Inverterschaltung (BUFF) eingegebenes Auswahllogiksignal angesteuert wird und mit der Betriebsspannung (VX) über einen zweiten P-MOS-Schalttransistor (Pullup 3) verbunden ist,
- ein erster P-MOS-Rückkopplungstransistor (TP4) ein Gate (Knoten 18) besitzt, das direkt durch den Ausgangsknoten (Knoten 1) angesteuert wird, wobei der erste Rückkopplungstransistor zwischen die Betriebsspannung (VX) und den Gatebereich (Knoten 6) des zweiten Schalttransistors (pull-up 3) eingefügt ist,
- ein zweiter N-MOS-Rückkopplungstransistor (TN5) ein Gate besitzt, das direkt durch den Ausgangsknoten (Knoten 1) angesteuert wird, wobei der zweite Rückkopplungstransistor zwischen den Verbindungsknoten (Knoten 6) zwischen dem ersten Rückkopplungstransistor (TP4) und dem Gate-Bereich des zweiten Schalttransistors (pull-up 3) und den Eingangsknoten (Knoten 0) des Gates des ersten Schalttransistors (pull-down 2) eingefügt ist, und
wobei der Verbindungsknoten (Knoten 6) zwischen dem ersten Rückkopplungstransistor (TP4) und dem Gate des zweiten Schalttransistors (pull-up 3) mit Masse über einen Entkopplungstransistor (TN1) des N-MOS-Typs verbunden ist, wobei das Gate des Entkopplungstransistors durch das Auswahlsignal angesteuert wird, das vom Verbindungsknoten (Knoten 5) zwischen dem Decodierungsabschnitt (NOR) und der Inverterschaltung (BUFF) empfangen wird.

2. Spannungsübersetzungsschaltung nach Anspruch 1, **dadurch gekennzeichnet, daß** die Schalttransistoren (pull-up 3, pull-down 2), die Rückkopplungstransistoren (TP4, TN5) und der Entkopplungstransistor (TN1) Hochspannungstransistoren (H-Transistoren) sind.
